# EUROPÄISCHE PATENTSCHRIFT

(11) **EP 0 563 735 B1**
(45) Veröffentlichungstag und Bekanntmachung des Hinweises auf die Patenterteilung: **18.08.1999**
(21) Anmeldenummer: 93104666.8
(22) Anmeldetag: 22.03.1993
(51) Int. Cl.: B32B 15/01, H01B 1/02, B23K 20/04, B23K 20/00

(54) **Verfahren zur Herstellung von korrosionsbeständigem Verbunddraht**
Process for manufacturing corrosion resistant composite wire
Procédé pour fabriquer un fil composite résistant à la corrosion

(30) Priorität: 31.03.1992 DE 4211167
(43) Veröffentlichungstag der Anmeldung: 06.10.1993
(73) Patentinhaber: Herborn & Breitenbach GmbH, 09112 Chemnitz (DE)
(72) Erfinder: Müller, Volker, Dr., O-6800 Saalfeld (DE); Fehn, Manfred, Dr., O-6800 Saalfeld (DE); Sommer, Hans, O-6800 Saalfeld (DE); Grunwald, Hans-Jürgen, O-3090 Magdeburg (DE); Höltge, Ulf, O-3038 Magdeburg (DE)
(74) Vertreter: Horn, Klaus, Dr.

(56) Entgegenhaltungen:
- EP-A- 0 225 983
- DE-A- 1 427 372
- DE-A- 1 919 052
- DE-A- 3 416 825
- FR-A- 899 543
- FR-A- 1 429 727
- GB-A- 2 085 330

## Beschreibung

Auf vielen technischen Gebieten, insbesondere im Bauwesen und in der Drahtseilindustrie, steigen die Anforderungen an die verwendeten Werkstoffe hinsichtlich Dauerfestigkeit und Korrosionsbeständigkeit. Um z.B. im Bauwesen den Auswirkungen des "Betonkrebses" entgegenzuwirken, wird nach Wegen gesucht, die technisch geeigneten aber kostspieligen, nichtrostenden Stähle durch preisgünstigere Werkstoffe zu ersetzen. Verzinkte, kunststoffbeschichtete oder mit einem Farbanstrich versehene Stahldrähte und Stahlseile erfüllen diese Forderung nur unzureichend, weil sie bestimmten einsatzbedingten Einschränkungen unterworfen sind, wie z.B. Temperatur, Problemen beim Schweißen und ein leicht zu beschädigendes oder sprödes Äußeres. Massive Edelstahldrähte sind jedoch für viele Anwendungen zu teuer oder werden den Anforderungen hinsichtlich Festigkeit und Alterungsbeständigkeit nicht gerecht.

In einer bekannten Anlage zur Herstellung von Profil- und Stabstahl mit nichtrostenden Außenschichten werden Bimetallknüppel, in denen die beiden Stoffe metallurgisch verbunden sind, zu Winkel-, Flach-, Vierkant- und Sechskantstahl sowie Rundstahl im Durchmesserbereich 10 - 50 mm warmgewalzt. Die Nachteile des nach diesem Verfahren hergestellten Stabmaterials bestehen in der begrenzten Festigkeit von unter 660 N/mm², im begrenzten Durchmesserbereich des hergestellten Rundstahls auf über 10 mm, der durch das Walzverfahren nicht zu erreichenden exakten konzentrischen Edelstahlauflage und der geringen Variationsmöglichkeit der Dicke der Edelstahlauflage von nur 20 - 25 Vol.-%. Eine Weiterverarbeitung dieses Rundstahls zu hochwertigen Drähten für Drahtseile ist nicht vorgesehen.

Aus der DE-A-3 416 825 ist ein Verbundmaterial zur Verwendung als hochfeste Federn und als Stützglieder bekannt, das herkömmlichen Stahlfedern entsprechende Festigkeitseigenschaften und eine hohe elektrische Leitfähigkeit aufweisen soll. Zum Erhalt dieser Eigenschaften besteht das Verbundmaterial aus einem Kupferkern und aus einer Hülle aus u.a. nichtrostendem Stahl, wobei das Verhältnis der Querschnittsfläche der Stahlhülle zum Gesamtquerschnitt zwischen 0,1 und 0,8 liegen muß. Zur Herstellung eines derartigen Verbundstranges kann ein Kupferdraht mit einem Stahlblech umhüllt werden, das an seinen Längsrändern zusammengeschweißt wird. Zum Erhalt des geforderten Querschnittsverhältnisses zwischen Außenhülle und Kern sowie einer ausreichenden Zugfestigkeit, wird das Material wiederholten Walzungen oder Ziehvorgängen und Wärmebehandlungen sowie einer finalen Kaltverformung unterworfen. Eine verbesserte Haftung zwischen Kern und Stahlhülle wird durch eine Erwärmung des gesamten Materials auf über 800 °C erreicht, was gleichzeitig die Umformeigenschaften der verfestigten nichtrostenden Stahlhülle begünstigt aber das Gefüge des Kerndrahtes beeinträchtigt.

Ferner ist aus der EP-A-0 225 983 ein Verfahren zur Herstellung eines korrosionsbeständigen Verbundstranges bekannt, bei welchem ein Kernstrang aus Stahl mit einer korrosionsfesten Metallage umhüllt und das erhaltene Strangmaterial zur Erzielung einer metallurgischen Bindung zwischen Stahlkern und Hüllmetall nach einer Durchwärmung auf 900 bis 1250 °C warmgewalzt und schließlich mit einer vorgegebenen Rate abgekühlt wird.

Aufgabe der Erfindung ist es, ein Verfahren zur Herstellung eines korrosionsbeständigen Verbunddrahtes mit Durchmessern unter 10 mm aufzuzeigen, der universell einsetzbar ist und auch in kritischen Umgebungen unter wechselnden Beanspruchungen eine hohe Dauerfestigkeit und eine hohe Korrosionsbeständigkeit aufweist.

Diese Aufgabe wird erfindungsgemäß durch die im Patentanspruch 1 angegebenen Merkmale gelöst.

Das erfindungsgemäße Verfahren erlaubt eine kostengünstige Herstellung verschiedenartiger Verbunddrähte im kontinuierlichen Durchlauf. Durch den steuerbaren gezielten Wärmeeintrag in die außenliegende Metallschicht wird der beim Umformen in den Ziehschritten eintretenden Aushärtung der Außenschicht wirksam entgegengewirkt, ohne die Gefügestruktur des Kernmaterials nachteilig zu beeinflussen. Darüber hinaus wird durch die wiederholten Zieh- und Glühvorgänge eine hochfeste Verbindung zwischen der zuvor aktivierten Oberfläche des Kernmaterials und der Innenfläche der Metallhülle erzielt, die wesentlich zu der hohen Gesamtfestigkeit und Korrosionsbeständigkeit des neuen Verbunddrahtes beiträgt.

Nach dem erfindungsgemäßen Verfahren werden Verbunddrähte aus einer Edelstahlhülle und einem Stahlkern oder einer Edelstahlhülle und einem Kupferkern sowie auch aus anderen Metallkombinationen mit aufeinander abgestimmten Eigenschaften und Gefügestrukturen hergestellt. Bereits bestehende Ziehanlagen können mit relativ geringem Aufwand zur Herstellung der erfindungsgemäßen Verbunddrähte umgerüstet werden.

Gegenüber bekanntem korrosionsbeständigem Verbund-Stranggut hat der erfindungsgemäße Verbunddraht die Vorteile einer universellen Einsetzbarkeit, z.B. als Ausgangsmaterial für hochwertige Seile, als Armierungselemente im Bauwesen sowie in allen technischen Gebieten, in denen bisher ausschließlich Kupfer für die Außenschicht oder Edelstahl (massiv) eingesetzt werden durften.

Aufgrund der festen Verbindung der Außenhülle mit dem Kerndraht werden Zugfestigkeiten erreicht, die mit vergleichbarem bekannten Strangmaterial (Stahl-Kupfer) nicht ohne weiteres erzielt werden konnten. Da der den Hauptbestandteil bildende Kerndraht aus einem preiswerten Werkstoff besteht, ergibt sich zusätzlich ein gravierender Kostenvorteil gegenüber Volledelstahldraht.

Mit dem erfindungsgemäßen Verfahren kann ein zunderbeständiger Kupferdraht erzeugt werden, der bei guter elektrischer Leitfähigkeit eine ausgezeichnete Beständigkeit gegen korrosive Einflüsse infolge hoher Temperaturen aufweist. Die Vorteile dieses Verbunddrahtes werden in der ausgezeichneten elektrischen Leitfähigkeit, der hohen Oberflächenfestigkeit sowie der Temperatur- und Korrosionsbeständigkeit gesehen. Dieser Verbunddraht kann u.a. als neuartiger elektrischer Anschlußdraht für Heizelemente verwendet werden.

Weitere Vorzüge und Besonderheiten der Erfindung sind der folgenden Beschreibung einer Anlage zur Durchführung des Hestellungsverfahrens entnehmbar, die als Ausführungsbeispiel in der beiliegenden Zeichnung schematisch dargestellt ist. Es zeigen:
- Fig. 1: die Fertigungsanlage zum Ummanteln des Kerndrahtes
- Fig. 2: die Zieh-Glühanlage zur Herstellung des erfindungsgemäßen Verbunddrahtes
- Fig. 3: eine in der Fertigungsanlage nach Fig. 2 als Glühstation eingesetzte Lichtbogeneinrichtung
- Fig. 4: bevorzugte Ausführungsform einer Anlegezugvorrichtung
- Fig. 5: eine weitere Ausführungsform einer Anlegezugvorrichtung.

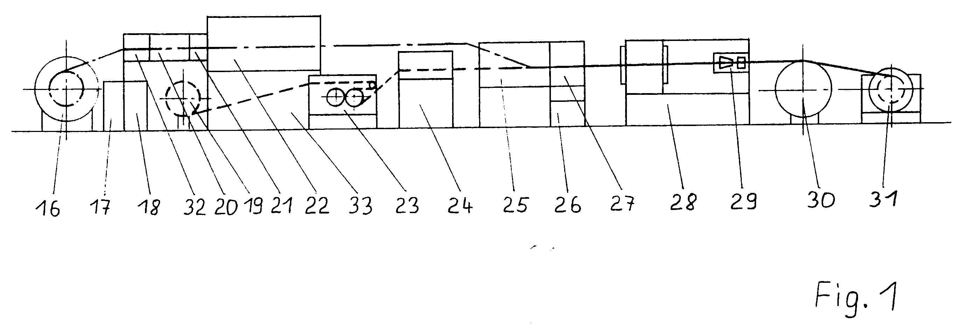

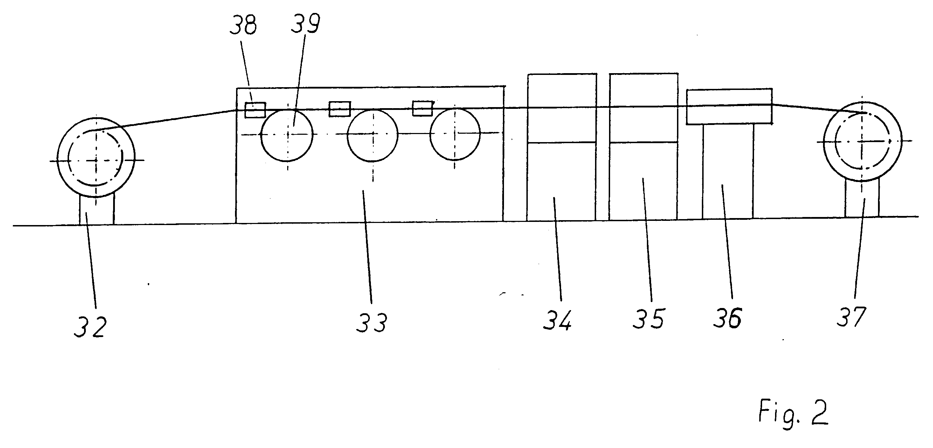

In der in Fig. 1 dargestellten Fertigungsanlage wird ein oberflächenbehandelter, z. B. gebürsteter, und von Anlagerungen befreiter Kerndraht aus hochfestem Stahl in einer Ummantelungsstation mit einem zu einem Rohr geformten und längsgeschweißten Edelstahlband kontinuierlich umhüllt.
Gem. Fig. 2 wird in nachfolgenden Zieh- und Glühstufen das Hüllrohr mit dem Kerndraht formschlüssig und dauerhaft verbunden. Eine gründliche Reinigung und Vorbehandlung der miteinander zu verbindenden Oberflächen ist eine wesentliche Forderung zum Erhalt einer ausreichend festen und störungsfreien Verbundwirkung.

Eine mit blankem, rundem Kerndraht bewickelte Trommel wird in eine Ablaufeinrichtung 16 eingesetzt. Der Drahtanfang der jeweiligen Trommel wird mit Hilfe einer Drahtstumpfschweißeinrichtung 17 mit dem Ende des in der Drahtstrecke befindlichen Drahtes verbunden. Nach der Bearbeitung der Schweißstelle kann die Ummantelungsanlage in Betrieb gesetzt werden. Der Draht durchläuft nach Passieren einer Drahtrichteinrichtung 32 eine Ultraschall-Reinigungsstation 20, um die an der Drahtoberfläche eventuell noch anhaftenden Ziehmittel bzw. sonstigen Fremdbestandteile zu beseitigen.

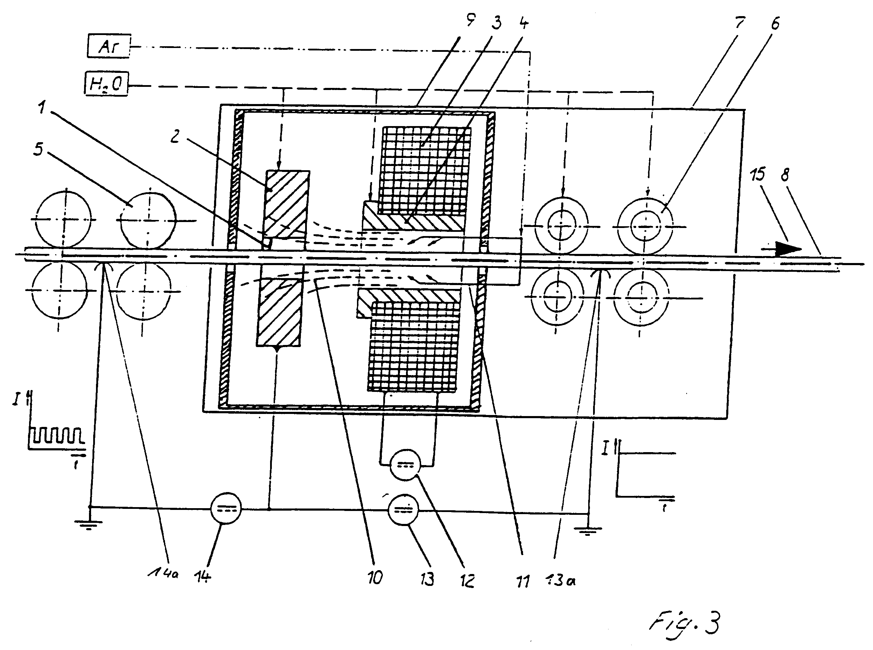

Als Reinigungsmittel in der Ultraschall-Reinigungsstation 20 werden wasserlösliche, biologisch bzw. chemisch abbaubare Medien verwendet. Alternativ oder zusätzlich kann zur Entfernung von anhaftenden Oberflächenbelägen eine Lichtbogeneinrichtung gemäß Fig. 3 eingesetzt werden. Der gereinigte und trockene Stahldraht läuft durch eine weitere Drahtrichteinrichtung 21, und eine Bürsteinrichtung 22 unter Schutzgas in eine Ummantelungsstation 25 ein. Die Einlenkung des Drahtes in die Achse der Ummantelungsstation 25 erfolgt vor oder nach der Drahtbürsteinrichtung 22 oder Lichtbogeneinrichtung.

Das in Fig. 1 als Strichlinie dargestellte Edelstahlband wird mittels geeigneter Transportmittel einer nicht näher dargestellten Doppelschwenkhaspel aufgegeben. Durch das Verbinden der Bandlängen mehrerer Kleinbunde in einer Bandquerschweißeinrichtung 18 und Aufhaspeln auf eine Doppelspeicherhaspel 19 entstehen Edelstahl-Großbunde, die in ihrer Bandlänge etwa der Drahtlänge einer Stahldrahtspule der Ablaufeinrichtung 16 entsprechen.

Das Edelstahlband durchläuft nach Passieren eines Bandtänzers, der der Antriebsregelung der ablaufenden Seite der Doppelspeicherhaspel 19 dient, eine Bandreinigung 33, in der eventuell an der Oberfläche anhaftende Bestandteile entfernt werden. Auch hier findet das Prinzip der Ultraschallreinigung mit wasserlöslichen, biologisch bzw. chemisch abbaubaren Medien Anwendung. In einer nachfolgenden Bandbesäumschere 23 wird das gereinigte Edelstahlband auf die dem zu formenden Rohrdurchmesser entsprechende Bandbreite geschnitten. Zur weiteren optimalen Vorbereitung der Edelstahlbandoberfläche wird, wie beim Stahldraht, insbesondere die zum Stahldraht weisende Bandoberfläche in einer Bürststation 24 mittels rotierender Rundbürsten behandelt, um von adhäsiven Schichten befreite Flächen hoher Aktivität zu erzeugen. Das Edelstahlband läuft nach dem Bürsten, wie auch der behandelte Stahlstahl, bis zur gemeinsamen Umformung unter Schutzgas.

Das Edelstahlband wird in der Rohrprofilierung 25 kontinuierlich um den Kerndraht zu einem Rohr mit obenliegendem Längsschlitz und innenliegendem Stahldraht geformt. In einer unmittelbar nachgeordneten Rohrschweißeinrichtung 27 wird der Längsschlitz im kontinuierlichen Durchlauf nach dem WIG-Schweißverfahren ohne Zusatzwerkstoff mittels Mehrelektrodenbrenner direkt verschweißt. Es können auch andere Hochgeschwindigkeits-Schweißverfahren, wie Elektronenstrahl- oder Laser-Schweißen, angewendet werden.

Das Profilieren und Rohrschweißen erfolgt in einer geschlossenen Haube unter Schutzgas. Zur Einstellung des Brenners und Beobachtung des Schweißprozesses dient eine Schweißpunktoptik.

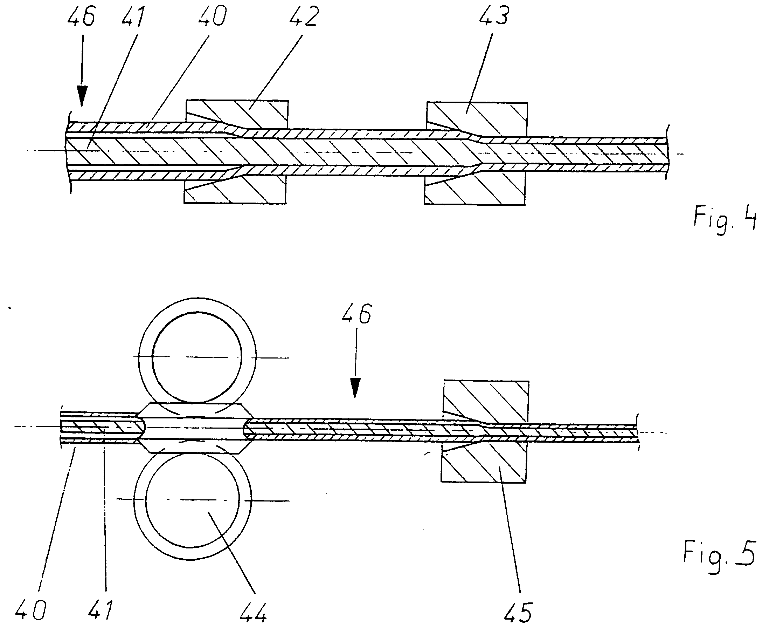

Anschließend gelangt das Edelstahlrohr 40 mit innenliegendem Kerndraht 41 gem. Fig. 4 oder 5 in eine Anlegezugvorrichtung 28.
Diese besteht nach der Ausführungsform gem. Fig. 5 aus einer einlaufseitig angeordneten Walzeinrichtung in Form eines Vierwalzenkalibers 44, welche den Edelstahlmantel 40 dicht an den Kerndraht 41 heranwalzt - ein Aufdrücken des Edelstahlmantels 40 auf den Kerndraht 41 an dieser Steile ist nicht zulässig, da zwischen Kerndraht 41 und Edelstahlmantel 40 noch Relativgeschwindigkeiten auftreten - und auslaufseitig einer Zieheinrichtung 29. Nach Beschichtung 46 der Oberfläche des Edelstahlmantels 40 mit einem Ziehmittelträger (wäßrige Lösung auf Boraxbasis) wird mittels des in der Zieheinrichtung 29 angeordneten Ziehsteins 45 eine Umformung von 8 - 15 % realisiert. Es erfolgt eine gemeinsame Umformung von Edelstahlmantel 40 und Kerndraht 41.
Wesentlich ist hierbei, daß der Edelstahlmantel 40 vor Einlauf in das Vierwalzenkaliber 44 gekühlt werden muß. Ansonsten würde die Gefahr des Aufheizens in den Lagern des Vierwalzenkalibers 44, infolge der durch den Rohrschweißprozess eingebrachten Wärme, bestehen. Nach Durchlauf des Vierwalzenkalibers 44 ist wiederum ein Erwärmen des Edelstahlmantels 40 zum Trocknen des aufgebrachten Ziehmittelträgers vorteilhaft.
Fig. 4 zeigt die bevorzugte Ausführungsform einer Anlegezugvorrichtung 28.
Statt der vorgenannten Walzeinrichtung wird eine Zieheinrichtung mit Ziehstein 42 verwendet. Dieser Ziehstein 42 bewirkt ebenfalls ein dichtes Heranbringen des Edelstahlmantels 40 an den Kerndraht 41.
Die Beschichtung 46 des Edelstahlmantels 40 mit dem Ziehmittelträger erfolgt direkt hinter der Rohrschweißeinrichtung 27, so daß ein Trocknen des Ziehmittelträgers infolge der durch den Schweißprozeß eingebrachten Wärme gewährleistet ist.
Dem Ziehstein 42 ist dann ein weiterer Ziehstein 43, der die gewünschte Umformung von 8 - 15 % realisiert, nachgeordnet. Nach diesem Anlegezug gem. Fig. 4 oder 5 ist ein sicherer Formschluß (Preßsitz) zwischen Kerndaht 41 und Edelstahlmantel (40) gewährleistet.

Ein Scheibenabzug 30 bewirkt den Transport der Materialien durch die Anlageneinrichtungen. Mit Hilfe eines Aufwicklers 31 wird der ES-Halbzeugdraht auf Trommeln gewickelt und steht in dieser Form als Ausgangsmaterial für die Weiterverarbeitung in nachfolgenden Zieh-und Glühschritten zur Erzielung eines Verbundes zwischen Kerndraht und Hülle zur Verfügung.

Die Ummantelungsanlage wird zentral von einem Hauptsteuerpult 26 aus betrieben, das in unmittelbarer Nähe der Rohrschweißeinrichtung 27 angeordnet ist, um die Beobachtung des Schweißprozesses durch den Anlagenfahrer zu erleichtern.

Zur Erzielung eines Verbundes zwischen Kerndraht und Hülle aus Edelstahl sind die schon vorbeschriebenen Zieh- und Glühschritte ein nicht zu vernachlässigendes Erfordernis.

Fig. 2 zeigt die für den ersten Zieh-Glühprozeß bevorzugte Ausführung einer Zieh-Glühanlage. Der auf Trommeln befindliche ES-Halbzeugdraht wird in eine Ablaufeinrichtung 32 eingesetzt. Die nach der Ablaufeinrichtung befindliche Ziehmaschine 33 sorgt für eine weitere Umformung des Drahtes. Die vor den Ziehscheiben 39 angeordneten Ziehsteinkästen 38 sind mit je zwei Ziehsteinen, einem Vorstein zum genauen zentrischen Zuführen des Drahtes in den umformenden Ziehstein und dem eigentlichen umformenden Ziehstein, bestückt. Die Ziehscheiben 39 haben je einen Einzelantrieb. Durch die zwischen den Ziehscheiben vorhandene Regelung wird ein schonender gleitloser Ziehprozeß realisiert. Nach 65 % Umformung ist die weitere Umformfähigkeit des Edelstahlmantels erschöpft, der Kerndraht könnte weiter umgeformt werden. Der Draht durchläuft danach eine Ultraschallreinigungsanlage 34, um anhaftende Ziehmittel zu beseitigen. Das Reinigungsprinzip ist dem in der Ummantelungsanlage identisch. Danach wird der Draht in eine Lichtbogeneinrichtung 35 entsprechend Fig. 3 geführt. Zur Erzielung einer weiteren Umformfähigkeit des Edelstahlmantels wird nur dieser mittels der Lichtbogeneinrichtung 35 kurzfristig geglüht und abgekühlt, d. h. der Verbunddraht wird nur an seiner Oberfläche geglüht, der Kerndraht erreicht nur Temperaturen <400 °C (kein Glühen) und behält somit seine Eigenfestigkeit bzw. durch die Umformung (Ziehschritte) zusätzliche Festigkeit.
Nach diesem Zieh-Glühprozeß hat sich eine ausreichende Haftfestigkeit zwischen Kerndraht und Edelstahlmantel ausgebildet (vergleichbar mit einem Kaltpreß-Schweißvorgang). Danach durchläuft der Verbunddraht eine weitere Kühleinrichtung 36, die aber auch als Ziehmittelträgerbeschichtung genutzt werden kann, falls weitere Ziehumformungen folgen.
Mit Hilfe eines Aufwicklers 37 wird der Verbunddraht wieder auf Spulen gewickelt und steht in dieser Form als Fertigmaterial oder Ausgangsmaterial für weitere Ziehumformungen zur Verfügung.
Nach Gesamtquerschnittsabnahmen von ≥ 85 % sind Festigkeiten bis 2000 N/mm² erreichbar.

Die in Fig. 3 dargestellte Lichtbogeneinrichtung enthält in einem Kasten 7 eine auslaufseitig angeordnete Ringelektrode 2 zur Erzeugung eines Lichtbogens 1 zwischen ihrer Innenfläche und der Oberfläche des einlaufenden Verbunddrahtes 8. In Ablaufrichtung des Verbunddrahtes 8 hinter der Ringelektrode 2 ist eine Magnetspule 3 koaxial angeordnet, deren Kraftlinien eine Rotation des Lichtbogens 1 um den Draht 8 bewirken und eine vom durchlaufenden Draht 8 erzeugte, dem Mitnahmeeffekt entgegengerichtete Kraft auf den Lichtbogen 1 ausüben.

Durch Verwendung eines gepulsten Lichtbogenstroms kann dem Mitnahmeeffekt des Lichtbogens 1 zusätzlich entgegengewirkt und die Umlaufbewegung des Lichtbogens vergleichmäßigt werden.

Der Lichtbogen 1 wird von zwei unabhängig voneinander einstellbaren Gleichstromquellen 13, 14 gespeist, deren negative Ausgänge über Leitungen mit Schleifkontakten 13a, 14a verbunden sind, von denen einer 14a vor und der andere hinter der als Anode geschalteten Ringelektrode 2 angeordnet und mit dem Verbunddraht 8 elektrischleitend verbunden sind. Die Ringelektrode 2 ist an die positiven Ausgänge der beiden Stromquellen angeschlossen. Die Aufteilung des Lichtbogenstroms in zwei aus den jeweiligen Stromquellen 13, 14 stammende Teilströme ermöglicht eine wirksame Steuerung der auf den Fußpunkt des Lichtbogens einwirkenden Kräfte. Dabei ist ein Energieeintrag in das Werkstück (Draht 8) von 500 bis 1000 J/cm² zum Glühen der Edelstahlhülle bei Verbunddrähten 8 und weniger als 100 J/cm² zum Oberflächenreinigen erforderlich. Es wird ein Lichtbogen mit einer Länge von 2 bis 5 cm erzeugt. Die kathodenseitige Aufteilung des den Lichtbogen 1 speisenden Stromes auf die vor und hinter der Ringelektrode 2 befindlichen Anschlußkontakte 14a, 13a erfolgt im Verhältnis 1 : 1,5 bis 1 : 6. Die Ringelektrode 2 befindet sich im inhomogenen Magnetfeldbereich in einem vorbestimmten Abstand vor der hohlzylindrischen Magnetspule 3, deren Achse mit der Drahtachse identisch ist und die an eine zusätzliche Gleichstromquelle 12 angeschlossen ist. Die magnetische Durchflutung sollte einen Betrag > 5000 A aufweisen.

Die Ringelektrode 2 und die Magnetspule 3 sind in einem zur Drahtachse symmetrischen Gehäuse 9 aus magnetischem Material angeordnet, das einen magnetischen Rückschluß gewährleistet.

In Durchlaufrichtung 15 vor und hinter dem Gehäuse 9 sind Führungsrollen 5, 6 angeordnet, die eine Zentrierung des Drahtes 8 zur Ringelektrode 2 bewirken. Die hinter der Ringelektrode 2 angeordneten Führungsrollen 6 sind an eine Wasserkühlung angeschlossen. Das Gehäuse 9 und die abzugsseitigen Führungsrollen 6 sind innerhalb des mit Schutzgas gefüllten Kastens 7 angeordnet, der Durchführungsöffnungen für den Draht 8 enthält. Die Zufuhr des Schutzgases erfolgt in Durchlaufrichtung 15 hinter der Ringelektrode 2 durch Düsen 11, die von mehreren Seiten auf den Draht 8 gerichtet sind.

Am stärksten wirkt sich die Beeinflussung des Lichtbogens 1 durch kathodenseitige Teilung des elektrischen Lichtbogenstroms aus. Der gegen die Durchlaufrichtung 15 des Drahtes 8 über den Anschlußkontakt 13a zugeführte Teilstrom bewirkt eine Kraft in derselben Richtung auf den Fußpunkt des Lichtbogens 1. Der zweite, vom ersten unabhängige, in Durchlaufrichtung 15 im Draht 8 fließende Teilstrom ist erforderlich, um bei konstantem Gesamtbogenstrom (Summe der Teilströme) diese Kraftwirkung ohne Verschiebung des Bogenfußpunktes steuern zu können. Als positiv erweist sich hier außerdem, daß die thermische Belastung des Kernmaterials durch Stromsplitting im Vergleich zur einseitigen Stromeinspeisung reduziert wird.

Das äußere Magnetfeld, dessen Feldlinien 10 im Bereich der Ringelektrode 2 achsparallel verlaufen, bringt den zwischen der Ringelektrode 2 und dem Draht 8 stehenden Lichtbogen 1 zum Rotieren um den Draht 8. Diese Rotation erzeugt eine Komponente des Lichtbogens 11, die orthogonal auf der von den Magnetfeldlinien 10 und dem idealen, stehenden Lichtbogen 11 aufgespannten Ebene steht (Rotationskomponente). Das äußere Magnetfeld wird von der kernlosen Magnetspule 3 erzeugt, deren Magnetfeldlinien 10 im Spuleninneren in Achsnähe achsparallel verlaufen. Verschiebt man die Ringelektrode 2 auf der Magnetspulenachse aus der Magnetspule 3 heraus, so sind mit wachsender Entfernung von derselben Magnetfeldanteile festzustellen, die orthogonal auf der Drahtachse stehen (Divergenzkomponente). Die Rotationskomponente des Lichtbogens 1 ergibt in Verbindung mit der Divergenzkomponente des Magnetfeldes eine Kraftwirkung auf den Lichtbogen 1, die - unabhängig von der Richtung des Magnetfeldes - von der Magnetspule 3 weg weist. Um diese Kraft gegen den Mitnahmeeffekt des durchlaufenden Drahtes 8 wirken zu lassen, wurde die Magnetspule 3 in Stablaufrichtung 15 hinter der Ringelektrode 2 angeordnet.

Der Schutzgasstrom ist zweckmäßigerweise entgegen der Durchlaufrichtung 15 gerichtet. Das bewirkt zum einen eine Kraft auf den Lichtbogen 1, die den Mitnahmeeffekt reduziert, und zum anderen umströmt so das neu zugeführte, kalte Schutzgas den thermisch behandelten, heißen Draht 8 und trägt zur Kühlung bei. Des weiteren werden vom Lichtbogen 1 abgelöste Oberflächenverschmutzungen des Drahtes 8 sofort aus der Wärmezone geblasen.

Die Überlagerung des Bogenstroms mit Impulsen führt zur Ausbildung eines steifen Lichtbogens 1 und zu einer leichten Verschiebbarkeit des kathodenseitigen Fußpunktes des Lichtbogens 1 auf der Staboberfläche, was den Mitnahmeeffekt zusätzlich vermindert. Da die Bogenrotationsfrequenz um ca. 500 Hz liegt, ist eine Strompulsfrequenz von ca. 5 kHz bei einer Pulshöhe von 15 % des Bogenstroms anzustreben.

Der nach dieser Technologie hergestellte ES-Verbunddraht zeichnet sich durch hervorragende Korrosionsbeständigkeit aus und besitzt eine konzentrische und homogene Edelstahlauflage über den Querschnitt und die gesamte Drahtlänge mit guter Oberflächenqualität. Die Edelstahlauflage kann, je nach eingesetzter Edelstahlbanddicke, 15 - 30 Vol. % betragen.

Aus dem erfindungsgemäßen Verbunddraht können z. B. Anker und Nadeln zur Befestigung von Betonelementen und Dämmstoffschichten in mehrschaligen Betonkonstruktionen hergestellt werden. Ferner können die Verbunddrähte als Bewehrungsdrähte und -matten in dünnwandigen, flächigen und/oder filigranen Betonelementen, z. B. für Dachkonstruktionen; verwendet werden, die über lange Zeiträume korrosiven Einwirkungen ausgesetzt sind. Weitere Anwendungen sind Sicherungsseile im Verkehrswesen, im Schiffbau und in Industrieanlagen, Befestigungsdrähte im Garten- und im Weinbau usw., sowie Spann- und Zugmittel in Ingenieurbauten mit hohen Anforderungen an die Festigkeit des Materials und gleichzeitiger Forderung nach geringer Masse, wie insbesondere Brückenbauten.

Ein betrieblicher Vorzug des erfindungsgemäßen Verfahrens liegt noch darin, daß herkömmliche Edelstahl-Drahtziehanlagen auf einfache Weise umgerüstet werden können, um den Verbunddraht auf Endmaß zu verarbeiten. Es sind lediglich eine oder mehrere Lichtbogen-Glühvorrichtungen an vorbestimmten Stellen der Ziehstrecke zu positionieren. In Ziehversuchen wurde das ummantelte Material mit einem Durchmesser von 7,6 mm auf einen Durchmesser von 2,5 mm gezogen. Beim Durchmesser von 5,6 mm wurde ein Zwischenglühen im Durchlauf mittels magnetisch bewegtem Lichtbogen durchgeführt.

Edelstahlplattierte Drähte können nach diesem Verfahren mit Endfestigkeiten ≤ 2000 N/mm² hergestellt werden. Entscheidend für die Größe der Festigkeit sind dabei die gewählte Kerndrahtqualität und der Umformgrad des Ziehprozesses.

Der Kostenvorteil gegenüber Volledelstahldraht beträgt 30 - 50 %.

## Patentansprüche

1. Verfahren zur Herstellung eines korrosionsbeständigen Verbunddrahtes, bei welchem
- ein oberflächenbehandelter Kerndraht mit einem längsgebogenen besäumten Edelstahlband umhüllt und die Metallhülle längsgeschweißt wird,
- die Metallhülle mit dem Kerndraht durch einen Anliegendziehvorgang formschlüssig verbunden wird,
- der so gebildete Draht in nachfolgenden Ziehschritten, bei denen sich zwischen Kerndraht und Metallhülle eine einem Kaltpreß-Schweißvorgang vergleichbare Haftfestigkeit ausbildet, auf Endmaß umgeformt wird und
- der Verbunddraht zwischen den Ziehschritten nach einer Querschnittsabnahme von etwa 65 % zur Wiederherstellung der Umformfähigkeit der Metallhülle bei Beibehaltung der erzielten Festigkeit des Kerndrahtes mittels eines magnetisch um den Verbunddraht rotierenden Lichtbogens derart kurzfristig zwischengeglüht wird, daß nur die Metallhülle die Glühtemperatur erreicht.

2. Verfahren nach Anspruch 1, dadurch gekennzeichnet, daß der Kerndraht mittels Ultraschallreinigung von anhaftenden Ziehmittelresten befreit wird und nachfolgend zur Beseitigung von Oberflächenschichten eine Vorbehandlung mittels Drahtbürsten erfolgt.

3. Verfahren nach Anspruch 1 oder 2, dadurch gekennzeichnet, daß der Kerndraht mittels eines rotierenden Lichtbogens von adhäsiv gebundenen Oberflächenschichten befreit wird.

4. Verfahren nach einem der Ansprüche 1 bis 3, dadurch gekennzeichnet, daß der Lichtbogen von zwei unabhängig voneinander einstellbaren Gleichstromquellen erzeugt wird.

5. Verfahren nach einem der Ansprüche 1 bis 4, dadurch gekennzeichnet, daß dem Lichtbogenstrom zur Erzeugung des Lichtbogens Impulse überlagert werden.

6. Verfahren nach einem der Ansprüche 1 bis 5, dadurch gekennzeichnet, daß das Zwischenglühen des Verbunddrahtes in einem gegen die Durchlaufrichtung gerichteten Schutzgasstrom erfolgt.

7. Verfahren nach einem der Ansprüche 1 bis 6, dadurch gekennzeichnet, daß als Kerndraht ein Stahldraht verwendet wird.

8. Verfahren nach einem der Ansprüche 1 bis 6, dadurch gekennzeichnet, daß als Kerndraht ein Kupferdraht verwendet wird.

## Claims

1. A process for the production of a corrosion-resistant composite wire, in which
- a surface-treated core wire is sheathed with a longitudinally bent trimmed high-quality steel strip and the metal sheath is longitudinally welded,
- the metal sheath is positively lockingly joined to the core wire by a drawing operation in mutually contacting relationship thereof,
- the wire formed in that way is transformed to its final size in successive drawing steps in which adhesion comparable to a cold pressing welding operation is produced between the core wire and the metal sheath, and
- between the drawing steps after a reduction in cross-section of about 65%, to restore the transformation capability of the metal sheath while retaining the achieved strength of the core wire the composite wire is subjected to short-term intermediate annealing by means of an arc which magnetically rotates around the composite wire, in such a way that only the metal sheath reaches the annealing temperature.

2. A process according to claim 1 characterised in that the core wire is freed of drawing agent residues clinging thereto by means of ultrasonic cleaning and a preliminary treatment by means of wire brushes is then effected to remove surface layers.

3. A process according to claim 1 or claim 2 characterised in that the core wire is freed of adhesively bonded surface layers by means of a rotating arc.

4. A process according to one of claims 1 to 3 characterised in that the arc is produced by two mutually independently adjustable direct-current sources.

5. A process according to one of claims 1 to 4 characterised in that pulses are superimposed on the arc current to produce the arc.

6. A process according to one of claims 1 to 5 characterised in that intermediate annealing of the composite wire is effected in a protective gas flow directed in opposite relationship to the passage direction thereof.

7. A process according to one of claims 1 to 6 characterised in that a steel wire is used as the core wire.

8. A process according to one of claims 1 to 6 characterised in that a copper wire is used as the core wire.

## Revendications

1. Procédé pour fabriquer un fil composite résistant à la corrosion dans le cas duquel
- un fil central traité en surface est enveloppé par une bande en acier spécial rognée et courbée en longueur et la gaine métallique est soudée longitudinalement,
- la gaine métallique est solidarisée avec le fil central par conjugaison de forme par l'intermédiaire d'un procédé d'étirage avec mise en contact,
- le fil formé ainsi par étapes d'étirage successives, lors desquelles une force d'adhérence comparable à un procédé de soudage à froid se forme entre le fil central et la gaine métallique, est déformé pour obtenir sa dimension finale, et
- le fil composite est soumis pendant une période suffisamment courte au recuit intermédiaire entre les étapes d'étirement, après une réduction de section d'environ 65%, pour une restitution de la déformabilité de la gaine métallique tout en conservant la solidité obtenue du fil central au moyen d'un arc électrique pivotant magnétiquement autour du fil de raccordement, de telle façon que seule la gaine métallique atteint la température de recuit.

2. Procédé selon la revendication 1, **caractérisé en ce que** le fil central est libéré des restes du moyen d'étirement adhérents au moyen d'un nettoyage par ultra-sons et qu'un prétraitement pour l'élimination des couches superficielles est réalisé consécutivement au moyen de brosses métalliques.

3. Procédé selon la revendication 1 ou 2, **caractérisé en ce** que le fil central est libéré des couches superficielles liées de façon adhésive au moyen d'un arc électrique rotatif.

4. Procédé selon l'une des revendications 1 à 3, **caractérisé en ce que** l'arc électrique est créé par deux sources de courant continu réglables indépendamment l'une de l'autre.

5. Procédé selon l'une des revendications 1 à 4, **caractérisé en ce que** des impulsions sont superposées au courant de l'arc électrique qui sert à créer l'arc électrique.

6. Procédé selon l'une des revendications 1 à 5, **caractérisé en ce que** le recuit intermédiaire du fil composite s'effectue dans un courant de gaz protecteur dirigé à l'inverse du sens de déplacement.

7. Procédé selon l'une des revendications 1 à 6, **caractérisé en ce qu'**un fil en acier est utilisé comme fil central.

8. Procédé selon l'une des revendications 1 à 6, **caractérisé en ce qu'**un fil de cuivre est utilisé comme fil central.
